(19) Europäisches Patentamt
European Patent Office
Office européen des brevets

(11) **EP 2 037 506 B1**

(12) **EUROPEAN PATENT SPECIFICATION**

(45) Date of publication and mention
of the grant of the patent:
**24.07.2019 Bulletin 2019/30**

(51) Int Cl.:
*H01L 33/00* (2010.01)     *H01L 33/04* (2010.01)
*H01L 33/32* (2010.01)     *H01L 33/12* (2010.01)
*H01S 5/323* (2006.01)     *H01L 21/20* (2006.01)

(21) Application number: **07116583.1**

(22) Date of filing: **17.09.2007**

(54) **Semiconductor light emitting device with superlattices**

Lichtemittierende Halbleitervorrichtung mit Übergittern

Dispositif électroluminescent à semi-conducteurs en super-réseaux

(84) Designated Contracting States:
**DE FR GB**

(43) Date of publication of application:
**18.03.2009 Bulletin 2009/12**

(73) Proprietor: **Palo Alto Research Center Incorporated**
**Palo Alto, California 94304 (US)**

(72) Inventors:
• **Chua, Christopher L**
**San Jose, CA 95123 (US)**
• **Yang, Zhihong**
**Sunnyvale, CA 94086 (US)**
• **Johnson, Noble M.**
**Menlo Park, CA 94025 (US)**

(74) Representative: **Gill Jennings & Every LLP**
**The Broadgate Tower**
**20 Primrose Street**
**London EC2A 2ES (GB)**

(56) References cited:
**EP-A- 0 331 433**     **US-A- 6 069 367**
**US-A1- 2006 118 820**

• **REN Z ET AL: "Growth, characterization, and application of high Al-content AlGaN and high power III-nitride ultraviolet emitters" GAN, ALN, INN AND THEIR ALLOYS. SYMPOSIUM (MATERIALS RESEARCH SOCIETY SYMPOSIUM PROCEEDINGS VOL.831) MATERIALS RESEARCH SOCIETY WARRENDALE, PA, USA, 2005, pages 21-26, XP002469660 ISBN: 1-55899-779-2**
• **ADIVARAHAN V ET AL: "250 NM ALGAN LIGHT-EMITTING DIODES" APPLIED PHYSICS LETTERS, AIP, AMERICAN INSTITUTE OF PHYSICS, MELVILLE, NY, US, vol. 85, no. 12, 20 September 2004 (2004-09-20), pages 2175-2177, XP001226954 ISSN: 0003-6951**
• **FELTIN E ET AL: "STRESS CONTROL IN GAN GROWN ON SILICON (111) BY METALORGANIC VAPOR PHASE EPITAXY" APPLIED PHYSICS LETTERS, AIP, AMERICAN INSTITUTE OF PHYSICS, MELVILLE, NY, US, vol. 79, no. 20, 12 November 2001 (2001-11-12), pages 3230-3232, XP001102889 ISSN: 0003-6951**

## Description

TECHNICAL FIELD

The present invention is related generally to the field of semiconductor light emitting devices, and more specifically to an architecture for an improved high-Al content, low defect quantum well light emitting device formed directly on a final substrate.

BACKGROUND

In the III-V compound semiconductor family, the nitrides have been used to fabricate visible wavelength light emitting device active regions. They also exhibit a sufficiently high bandgap to produce devices capable of emitting light in the ultraviolet, for example at wavelengths between 290 and 400 nanometers. In particular, InAlGaN systems have been developed and implemented in visible and UV spectrum light emitting diodes (LEDs), such as disclosed in U.S. Patent 6,875,627 to Bour et al.. These devices are typically formed on an $Al_2O_3$ (sapphire) substrate, and comprise thereover a GaN:Si or AlGaN template layer, an AlGaN:Si/GaN superlattice structure for reducing optical leakage, an n-type electrode contact layer, a GaN n-type waveguide, an InGaN quantum well heterostructure active region, and a GaN p-type waveguide region. In addition, the complete device may also have deposited thereover a p-type AlGaN:Mg cladding layer and a capping layer below a p-type electrode.

While significant improvements have been made in device reliability, optical power output, and mode stability, the performance of the nitride-based lasers and light emitting diodes emitting in the ultraviolet (UV) is still inferior to that of their blue or violet counterparts. It is particularly true that for deep UV lasers and light emitting diodes operating at wavelengths below 340 nm, the nature of the substrate and template layer have a critical impact on the overall device performance. For example, differences in lattice constant between the substrate and the structural layers of the device significantly affects optical output and device lifetime. While $Al_2O_3$ (sapphire) as a substrate has numerous advantages, it is highly lattice mismatched to the structural layers of typical deep UV epi-layers. The prior art AlGaN template layer formed over the typical $Al_2O_3$ substrate mitigates the problem somewhat, but the resulting crystal quality of the high aluminium-containing structural layers in typical deep UV light-emitting devices utilizing these templates are still very poor.

The dislocation densities in AlGaN or AlN template layers on sapphire are typically in the mid $10^9$ to high $10^{10}$ cm$^{-2}$ range. As a consequence, the external quantum efficiencies of deep UV light emitting diodes in the 290 nm to 340 nm range are still well below the external quantum efficiencies for blue GaN-based LED structures. The high dislocation densities in typical Al-GaN or AlN template layers on sapphire also pose significant problems for the light emitting device lifespan.

The emission wavelength of the light emitting diode is inversely related to the Al content in the multiple quantum well heterostructure (MQWH) active region of the device. Thus, in order to obtain shorter wavelength devices, such as those emitting in the UV, the Al content of the MQWH region must be increased over that found in devices emitting in the visible spectrum. However, increasing the Al content presents a number of structural and device performance problems discussed below.

Efforts to improve the quality of the LED structure in the ultraviolet range on $Al_xGa_{1-x}N$/sapphire templates have presented significant challenges due to the high defect density of epitaxial layers formed over the AlGaN crystallographic template. In many cases, mechanical stresses lead to cracks in the heterostructure formed thereon. These issues are exacerbated when the Al content of layers formed above the AlGaN/sapphire system increases. Yet, as previously mentioned, an increased Al content (e.g., up to -50% in the MQWH active region of a 280 nm light emitting diode, and 60% to 70% in the surrounding AlGaN current and optical confinement layers) is required to obtain devices which emit in the UV.

Various groups have published approaches to dealing with these shortcomings. For example, Han et al., Appl. Phys. Lett, vol. 78, 67 (2001), discuss the use of a single AlN interlayer formed at low temperatures to avoid strain development. This low-temperature AlN interlayer approach has proven unsuccessful in the case of heterostructure growth with high Al mole fractions. Nakamura et al., J. J. Appl. Phys., vol. 36, 1568 (1997) has suggested short period GaN/AlGaN superlattice layers as a way of extending the critical layer thickness of AlGaN films grown pseudomorphically on GaN/sapphire. But the average Al mole fraction in these AlGaN/GaN systems is at such a low level (-10% or less) that it is not compatible with deep UV light emitting diodes. Chen et al., Appl. Phys. Lett., vol. 81, 4961 (2002) suggests an AlGaN/AlN layer as a dislocation filter for an AlGaN film on a Al-GaN/sapphire template. But again, the AlGaN/sapphire template presents the aforementioned series resistance problem. And Wong et al. in U.S. patent application 11/356,769, filed on February 17, 2006, published on May 17, 2007 as US 2007/0108456 A1, proposes a GaN/AlN superlattice formed between the GaN template layer and the MQWH active region. But again, the GaN template layer must be removed prior to light output for such a device.

Ren Z. et al., in "Growth, characterization, and application of high Al-content AlGaN and high power III-nitride ultraviolet emitters", Mater. Res. Soc. Symp. Proc. vol. 831, 21-26 (2005), study the use of graded superlattices before n-type AlGaN cladding layer growth. Using, on an AlN buffer layer, 30 period AlN/$Al_{0.89}Ga_{0.11}$N followed by 30 period $Al_{0.89}Ga_{0.11}$N/$Al_{0.53}Ga_{0.47}$N superlattices before n-AlGaN cladding layer growth, surface roughness is much improved.

Adivarahan V. et al., in "250 nm AlGaN light-emitting diodes", Appl. Phys. Lett., vol. 85, 2175-2177 (2004), report deep UV emission from LEDs integrating an $AlN/Al_{0.85}Ga_{0.15}N$ superlattice interposed between an AlN buffer layer and an AlGaN/AlGaN multiple quantum well light-emitting region.

Gaska R. et al., in US 2006/0118820 A1, published on June 8, 2006, disclose group III nitride-based light emitting heterostructures each having a strain-relief structure, such as typically a superlattice.

There is a need for a UV light emitting device apparatus with improved operation characteristics. Accordingly, there is a need for a method and structure facilitating a high Al content MQWH active region with reduced cracking and related damage.

## SUMMARY OF THE INVENTION

The present invention is directed to a semiconductor light emitting device in accordance with the appended claim 1. Advantageous embodiments of the present invention are the object of the appended dependent claims.

The semiconductor light emitting device in accordance with the present invention comprises: a strain relief structure above a structural region having a template surface over a substrate, said structural region containing aluminium in a first concentration, and below a semiconductor active layer containing aluminium in a second concentration, which is less than said first concentration. In accordance with the present invention, the strain relief structure comprises: a plurality of groups of at least two layers per group, at least one layer of each said group comprised at least in part of aluminium, such that each group has an average concentration of aluminium, the average concentration of aluminium varying from group to group such that the average concentration of aluminium in the group closest to the template layer is matched or approaching the first concentration and the average concentration of aluminium in the group nearest the active layer is matched or approaching the second concentration. Still in accordance with the present invention, each group of the strain relief structure comprises at least one layer sub-group, a first layer of the layer sub-group being comprised at least in part of aluminium and a second layer of the layer sub-group not including aluminium.

The present invention is directed to facilitating the growth of high aluminium content heterostructure active regions on an initial AlGaN surface for UV light emitting devices such as light emitting diodes (LED) and laser diodes (LD). The initial AlGaN surface can, for example be an AlN template on sapphire, an AlGaN template on silicon carbide, or a bulk AlN substrate. More specifically, the present invention is directed to semiconductor light emitting devices providing an improved transition from an initial $Al_xGa_{1-x}N$ surface (where $0 < x \leq 1$) to a high-Al content MQWH active region According to one embodiment of the present invention, a semiconductor light emitting device is formed beginning with a sapphire substrate on which is deposited an AlN template layer. A strain relief region is next formed over the template layer such that the average Al content of the strain region varies over its thickness. For example, the average Al content may go from a relatively high value, such as 80% or higher, adjacent the template layer to a relatively lower value, such as 60% or lower, adjacent the MQWH region. In this way, the average Al content of the strain relief region more closely matches the Al content of the regions contiguous thereto.

According to one aspect of the invention, the strain relief region is comprised of a variable period superlattice. The variable period superlattice may be comprised of two or more subsections of alternating layers of AlN of a first thickness and GaN of a second thickness. The thickness of the AlN layer decreases from subsection to subsection along the height of the strain relief region. The effect of this varying thickness of AlN is to vary the average Al content of that subsection. In this way, the average Al content may be decreased from one subsection to the next until an uppermost layer has the desired Al content. In one embodiment, the strain relief region comprises two such subsections. In another embodiment of the present invention the strain relief layer comprises more than two subsections.

According to another aspect of the invention, the variable period superlattice may be comprised of a continuum of alternating layers of AlN and GaN. The thicknesses of the AlN layers gradually decrease from one AlN/GaN pair to the next. In this way, the average Al content of the strain relief layer decreases from bottom to top, such that the bottom portion thereof matches or approaches the Al content of a layer contiguous thereto (e.g., the template layer), and the average Al content of the top portion matches or approaches the Al content of a layer contiguous thereto (e.g., the MQWH) so that an improved lattice match is provided at the region interfaces.

According to still another aspect of the invention, a pure AlN layer is deposited over the AlN template layer prior to deposition of the strain relief region. This AlN interface layer is generally thicker than the AlN layers of the strain relief region, and provides a transition from the template layer to the strain relief region.

Thus, the strain relief region of the semiconductor light emitting device according to the present invention provides a transition between a starting surface (such as a substrate, possibly with a template layer formed thereon) and the MQWH. Strain-induced cracking and defect density are reduced or eliminated.

## BRIEF DESCRIPTION OF THE DRAWINGS

In the drawings appended hereto like reference numerals denote like elements between the various drawings. While illustrative, the drawings are not drawn to scale. In the drawings:

Fig. 1 is a cross-sectional illustration of the general architecture of a heterostructure AlGaInN light emitting device structure in accordance with the present invention.

Fig. 2 is an illustration of the general architecture of a variable period variable composition superlattice strain relief region, and surrounding layers, according to one aspect illustrating the context of the present invention, but not defining it as such.

Fig. 3 is a cross-sectional illustration of an exemplary light emitting diode structure in accordance with the present invention.

Fig. 4 is a graphical depiction of a variable period variable composition strain relief region comprising two short-period groups of AlN/GaN layer pairs, illustrating the two respective periods of said groups.

Fig. 5 is an x-ray spectrum of a variable period variable composition superlattice grown on a reference GaN sample.

Fig. 6 is cross sectional view of a complete LED structure fabricated according to the present invention.

Fig. 7 is a comparison of the performance of an LED utilizing the variable period variable composition strain relief region of a semiconductor light emitting device according to the present invention to the performance of a prior art LED of identical structure with the exception of one GaN/AlN single-period superlattice strain relief region.

Fig. 8 is an optical micrograph of the top-most surface of an as-grown LED heterostructure according to the present invention.

## DETAILED DESCRIPTION

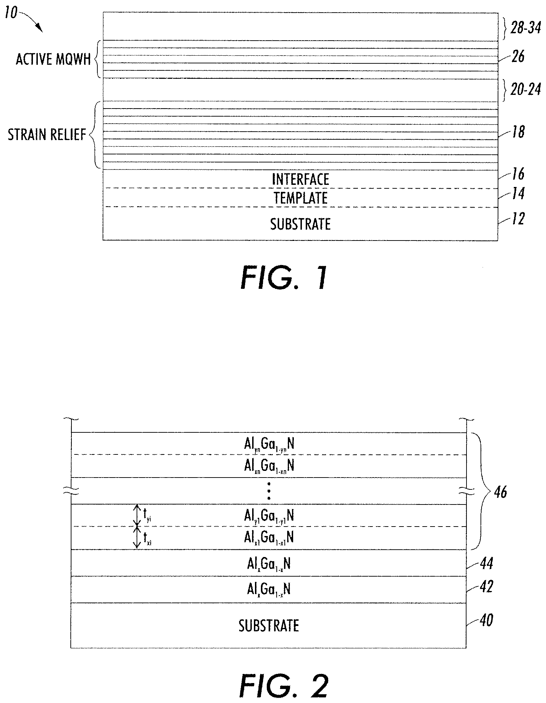

With reference now to Fig. 1, there is shown therein the general architecture of a heterostructure AlGaInN light emitting device structure 10 in accordance with the present invention. Diode structure 10 comprises a (transparent) substrate 12. According to one embodiment of the present invention, substrate 12 may be $Al_2O_3$ (sapphire) on which is formed a template layer 14 transparent to the wavelength of emission of the optical device in which it will be incorporated. As described further below, other substrates such as Silicon Carbide, bulk AlN, or bulk GaN may be employed. Template layer 14 may be AlN, but may also be $Al_xGa_{1-x}N$ where x is not equal to 1. In some cases, not forming part of the present invention as defined by the appended claims, template layer 14 is not necessary and is absent. Formed thereon is an optional interface layer 16. In the embodiment in which template layer 14 is AlN, interface layer 16, if present, is preferably also AlN.

Formed above interface layer 16 is variable period variable composition superlattice strain relief region 18 comprising a number of layer pairs, such as AlN/GaN, described further below. Additional layers, such as AlGaN:Si buffer layer 20, n-contact layer 21, AlGaN/AlGaN:Si superlattice n-strain layer 22 (which allows for increased cladding thickness and hence reduced optical leakage of subsequent layers), AlGaN:Si n-cladding (index guiding) layer 24, and active MQWH layer 26 (such as InAlGaN) may then be formed thereover.

Subsequent layer such as the following may also be formed on MQWH layer 26: an AlGaN:Mg p-cladding (index guiding) layer 28, an AlGaN:Mg buffer layer 30, an AlGaN/AlGaN:Mg p-strain layer 32, and a GaN:Mg capping layer 34. The aforementioned layers may be formed by any method know in the art, including but not limited to methods described in U.S. Patent 6,875,627 to Bour et al.. It will be appreciated that a complete device will also include electrodes, not shown, as well as other similar or alternative devices formed in the manner of an array in appropriate embodiments.

Prior art devices comprising a template layer may include a material such as GaN for the template which must be removed prior to device operation, or which result in significant layer cracking and/or high defect density. Other prior art devices that comprise a high Al-content layer grown directly on an AlN template layer will exhibit high strain due to lattice mismatch between the two adjacent materials. One aspect of the present invention addresses these problems through the introduction of a transition layer between an initial growth surface and a high Al containing active layer, the transition layer comprising of a novel variable period variable composition superlattice strain relief region.

Fig. 2 is an illustration of the general architecture of a variable period variable composition superlattice strain relief region, and surrounding layers, according to one aspect illustrating the context of the present invention, but not defining it as such. In this aspect, a layer 42, typically $Al_xGa_{1-x}N$ ($0 \leq x \leq 1$), is formed on substrate 40. While layer 42 is often referred to as a template layer, the combination of substrate 40 and layer 42 together form the template for the growth of additional layers. Over this template a variable period variable composition superlattice strain relief region 46 is formed which acts as a transition from the template to the MQWH active region, gradually or in step-wise fashion transitioning from the aluminium content of the template to the aluminium content of the active region.

As shown in Fig. 2, strain relief region 46 consists of a plurality of pairs of layers of the form $Al_{xi}Ga_{1-xi}N$, with a thickness $t_{xi}$, and $Al_{yi}Ga_{1-yi}N$, with a thickness $t_{yi}$, where $0<x\leq1$ and $0<y\leq1$. The plurality of layers are arranged in i groups where $2\leq i\leq n$. Thus, xi represents the aluminium content in a first layer of a layer pair of the $i^{th}$ group, and yi represents the aluminium content in a second layer of that layer pair in the $i^{th}$ group. The average aluminium content of each group, i, of layer 46 can be determined as follows:

$$\frac{t_{xi}x_i + t_{yi}y_i}{t_{xi} + t_{yi}}$$

Accordingly, by varying xi, yi, $t_{xi}$ and $t_{yi}$, the average aluminium content of each group of layer pairs can be controlled. Variable periodicity is achieved by varying the thickness $t_{xi}$ and $t_{yi}$ for different periods i, while variable composition is achieved by varying the compositions xi and yi for different periods i.

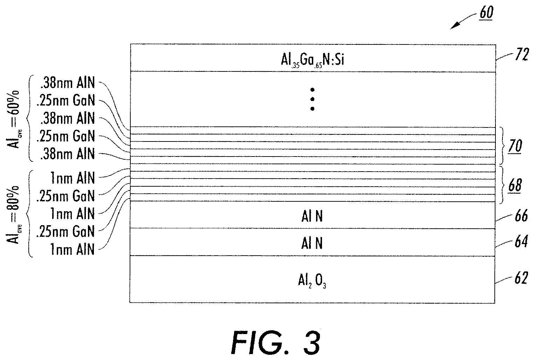

With reference now to Fig. 3, in order to demonstrate the concept underlying the present invention, we grew a light emitting diode (LED) structure 60 in accordance with the present invention, utilizing a two-group variable period variable composition superlattice strain relief region. We chose an AlN/GaN superlattice design with fixed composition (xi = 1 and yi = 0) for all periods. The LED is designed to operate at a wavelength λ of about 325 nm, requiring an active region heterostructure 72 with an Al composition of about 35%. The template layer 64 was a 1 μm thick epitaxial layer of AlN grown on a sapphire substrate 62 (in other words, with reference to Fig. 2, x = 1 in layer 42). A 25-30 nm thick AlN interface layer 66 was formed over template layer 64.

A first group 68 of 40 short period superlattice layer pairs of AlN/GaN were then formed over layer 64. We chose a first region average Al composition of 80%, and a second region average Al content of 60%, and tailored the layer thicknesses for xi = 1 and yi = 0 to produce these compositions as follows. In the first group 68 the thicknesses were $t_{xi}$ = 1 nm, $t_{yi}$ = 0.25 nm for 40 pairs (i = 1 to 40). In the second group 70 the thicknesses were $t_{xi}$ = 0.38 nm, $t_{yi}$ = 0.25 nm for the remaining 40 pairs (i = 41 to 80). This produced an AlN/GaN short period superlattice with an average Al composition of 80% for the first 40 pairs at the template end of the superlattice and 60% for the second 40 pairs at the heterostructure end. The thicknesses of the individual layers of the variable period superlattice, $t_{xi}$ and $t_{yi}$, are made very thin to minimize strain due to lattice mismatch.

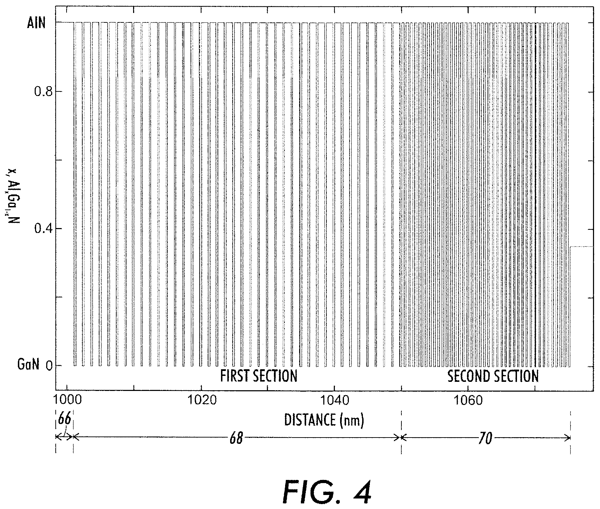

Fig. 4 is a graphical depiction of groups 68, 70 of the aforementioned LED 60, illustrating the two respective periods of said groups. As will be appreciated from Fig. 4, while the number of layer pairs in each group is the same, the difference in layer thickness results in group 68 being thicker than group 70.

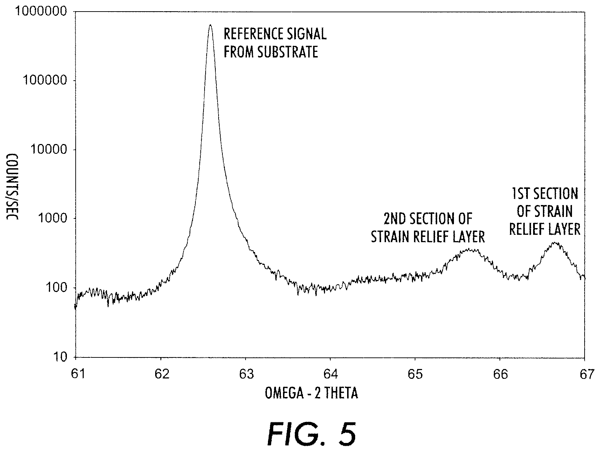

Referring next to Fig. 5, the graph shows an x-ray spectrum taken from a sample comprising the variable period superlattice of Figure 3 grown on a GaN on sapphire template. The GaN template produces a large main peak that is used as reference. The two side peaks come from regions 68 and 70 of Figure 3. Region 70 of Figure 3 has a lower average Al content than region 68, so it corresponds to the peak near the GaN reference peak. The X-ray peak occurring at the higher omega-2 theta angle comes from region 68. The two peaks correspond to the two different average Al contents within the two sections of the superlattice. Variable period superlattice with more than two different periods will have more than two X-ray peaks. Similar test samples comprising single period superlattice strain relief layers such as those employed in the aforementioned U.S. patent application 11/356,769 (US 2007/0108456 A1) will produce one peak.

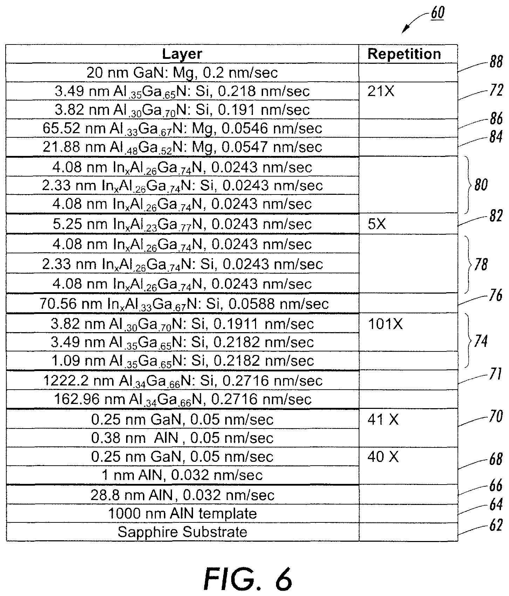

With reference to Fig. 6, a complete LED structure 60 according to the present invention is illustrated in cross section. In addition to the previously described elements, the structure incorporates n contact layer 71, n-cladding layer 74, n waveguide 76, barrier layers 78 (10.49 nm), 80 (89.19 nm), with quantum well 82 (5.25 nm) therebetween, tunnel barrier layer 84, and p waveguide and contact 86, 88. Some of these layers such as waveguide layers 76 and 84 allow the LED design to be easily extendable to laser diodes but do not perform actual waveguiding functions when the device is operated in LED mode.

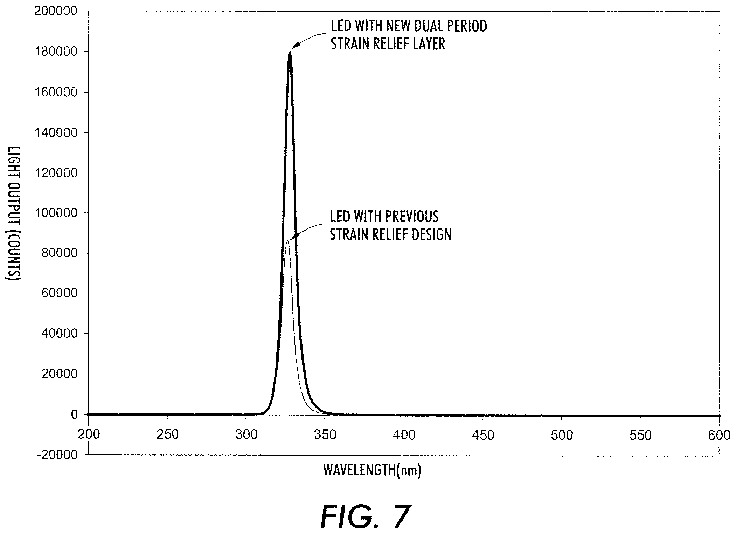

Referring now to Fig. 7, the performance of an LED utilizing the variable period variable composition superlattice strain relief region according to the light emitting device of the present invention is compared to a prior art LED of identical structure with the exception of one GaN/AlN single-period superlattice strain relief region. As can be seen, the light output of the LED incorporating the variable period variable composition strain relief region according to the light emitting device of the present invention demonstrated significantly brighter optical output than the LED grown on prior art single period binary superlattice strain relief layers. From this we conclude that devices incorporating the strain relief region taught herein benefit from enhanced optical output, due to the more gradual transition in Al content provided by the strain relief structure.

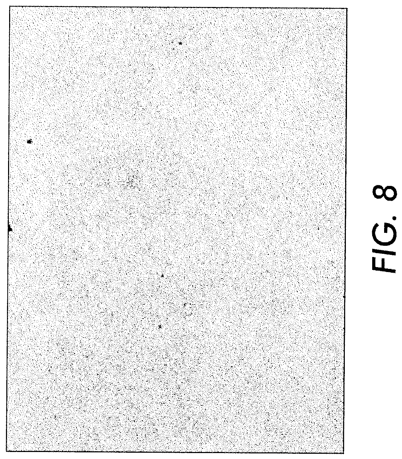

Figure 8 shows an optical micrograph of the topmost surface of an as-grown LED heterostructure manufactured with the variable period variable composition strain relief region of the light emitting device of the present invention. As can be seen, a substantially crack-free surface is produced.

It will be appreciated that while the foregoing describes an embodiment of the present invention utilizing a two-group, step-wise superlattice design, the concept extends to include many different region profiles, such as three or more groupings (e.g., with an average composition of approximately 80%, 70% and 60%, respectively), or although not forming part of the present invention as defined by the appended claims, continuously varying composition profiles, varying linearly, parabolically, exponentially or otherwise, each providing a different transition profile for the Al content in the region. For example, a three step superlattice would have three layers per period, each layer with aluminium contents of, say, xi, yi, zi and thicknesses txi, tyi, and txi for period i. A three-group superlattice would transition step-wise, with for example two steps per period, from the Al content matching or approaching that of the transition layer to the Al content matching or approaching that of the active region. The abrupt transition between layers within each period can also be replaced, although this does not form part of the present invention as defined by the appended claims, with a transition layer whose Al content varies continuously from a starting composition near that of the starting layer to an ending composition near that of the adjacent layer. The general case, however not defining the present invention as defined by the appended claims, would be a strain relief layer comprising a continuously varying composition profile starting with a composition close to that of the initial surface and ending with an Al composition close to that of the heterostructure active layer. In this illustrative only case, the continuous composition profile can be linear, parabolic, or can consist of curves with multiple points of inflection.

It is also common to add a small amount of indium in the aluminium containing alloys to improve structural quality. An example of a structure utilizing indium quaternary alloys in the structural layers has already been described in Figure 6. Indium, typically at a concentration of about 1% to 2%, can also be added to some or all of the layers within the strain relief structure.

Furthermore, while the discussion above has been focused towards multiple quantum well active regions, it will be appreciated by one skilled in the art that other types of light-emitting active regions such as double heterojunction (DH), homojunction, quantum wire, active regions incorporating nanometer scale compositional inhomogeneities (NCI), and single quantum well active regions could also be employed. Moreover, while the discussion has been focused on light emitting diodes (LEDs), it will be appreciated by one skilled in the art that the structures and methods described also applies to other types of semiconductor light emitting devices such as laser diodes and pump lasers.

## Claims

1. A semiconductor light emitting device (60) comprising:

   a strain relief structure above a structural region having a template surface over a substrate (62), said structural region containing aluminium in a first concentration; and below a semiconductor active layer (72) containing aluminium in a second concentration which is less than said first concentration; and wherein said strain relief structure comprises:

   a plurality of groups (68, 70) of at least two layers per group, at least one layer of each said group comprised at least in part of aluminium, such that each group has an average concentration of aluminium, the average concentration of aluminium varying from group to group such that the average concentration of aluminium in the group (68) closest to the template layer (64) is matched or approaching the first concentration and the average concentration of aluminium in the group (70) nearest the active layer (72) is matched or approaching the second concentration;

   wherein each group (68, 70) comprises at least one layer sub-group, a first layer of the layer sub-group comprised at least in part of aluminium and a second layer of the layer sub-group not including aluminium.

2. The semiconductor light emitting device of claim 1, wherein the average concentration of aluminium is higher in the group (68) closest to the template layer (64) relative to all groups in the strain relief structure, and the average concentration of aluminium is lower in the group (70) closest to the semiconductor active layer (72) relative to all groups in the strain relief structure.

3. The semiconductor light emitting device according to any of the preceding claims, wherein the semiconductor active layer (72) is a multiple quantum well heterostructure active region.

4. The semiconductor light emitting device of any of the preceding claims, wherein the average concentration of aluminium in the group (68) closest to the template layer (64) is in the range of 70-85%, and the average concentration of aluminium in the group (70) closest to the semiconductor active layer (72) is in the range of 50-65%.

5. The semiconductor light emitting device of any of the preceding claims, wherein the average concentration of aluminium varies linearly from group to group along the elevation of the strain relief structure.

6. The semiconductor light emitting device of claim 1, wherein the template layer (64) is composed of AlN.

7. The semiconductor light emitting device according to any of the preceding claims, further comprising an interface layer (66) formed above said template layer (64) and below said strain relief structure, said interface layer (66) having a composition matching the composition of said template layer (64).

## Patentansprüche

1. Lichtemittierende Halbleitervorrichtung (60), mit:

   einer Verformungsentspannungsstruktur über einem strukturellen Gebiet, das eine Schablonenfläche über einem Substrat (62) aufweist, wobei das strukturelle Gebiet Aluminium mit einer ersten Konzentration enthält; und unter einer aktiven Halbleiterschicht (72), die Aluminium mit einer zweiten Konzentration enthält, die kleiner ist als die erste Konzentration; und wobei die Verformungsentspannungsstruktur aufweist:

mehrere Gruppen (68, 70) aus mindestens zwei Schichten pro Gruppe, wobei mindestens eine Schicht jeder Gruppe zumindest teilweise aus Aluminium aufgebaut ist derart, dass jede Gruppe eine mittlere Konzentration an Aluminium hat, wobei die mittlere Konzentration an Aluminium von Gruppe zu Gruppe derart variiert, dass die mittlere Konzentration an Aluminium in der Gruppe (68), die der Schablonenschicht (64) am nächsten liegt, mit der ersten Konzentration übereinstimmt oder näherungsweise übereinstimmt, und die mittlere Konzentration an Aluminium in der Gruppe (70), die der aktiven Schicht (72) am nächsten ist, mit der zweiten Konzentration übereinstimmt oder näherungsweise übereinstimmt; wobei jede Gruppe (68, 70) mindestens eine Schichtenuntergruppe aufweist, wobei eine erste Schicht der Schichtenuntergruppe zumindest teilweise aus Aluminium aufgebaut ist, und eine zweite Schicht der Schichtuntergruppe Aluminium nicht enthält.

2. Lichtemittierende Halbleitervorrichtung nach Anspruch 1, wobei die mittlere Konzentration an Aluminium in der Gruppe (68), die der Schablonenschicht (64) am nächsten liegt, höher ist in Bezug auf alle Gruppen in der Verformungsentspannungsstruktur, und wobei die mittlere Konzentration an Aluminium in der Gruppe (70), die der aktiven Halbleiterschicht (72) am nächsten liegt, niedriger ist in Bezug auf alle Gruppen in der Verformungsentspannungsstruktur.

3. Lichtemittierende Halbleitervorrichtung nach einem der vorhergehenden Ansprüche, wobei die aktive Halbleiterschicht (72) ein aktives Heterostrukturgebiet mit mehreren Quantenwannen ist.

4. Lichtemittierende Halbleitervorrichtung nach einem der vorhergehenden Ansprüche, wobei die mittlere Konzentration an Aluminium in der Gruppe (68), die der Schablonenschicht (64) am nächsten ist, im Bereich von 70-85 % liegt, und wobei die mittlere Konzentration an Aluminium in der Gruppe (70), die der aktiven Halbleiterschicht (72) am nächsten ist, im Bereich von 50-65 % liegt.

5. Lichtemittierende Halbleitervorrichtung nach einem der vorhergehenden Ansprüche, wobei die mittlere Konzentration an Aluminium von Gruppe zu Gruppe entlang der Erhebung der Verformungsentspannungsstruktur linear variiert.

6. Lichtemittierende Halbleitervorrichtung nach Anspruch 1, wobei die Schablonenschicht (64) aus AlN zusammengesetzt ist.

7. Lichtemittierende Halbleitervorrichtung nach einem der vorhergehenden Ansprüche, die ferner eine Grenzflächenschicht (66) aufweist, die über der Schablonenschicht (64) und unter der Verformungsentspannungsstruktur ausgebildet ist, wobei die Grenzflächenschicht (66) eine Zusammensetzung hat, die mit der Zusammensetzung der Schablonenschicht (64) übereinstimmt.

**Revendications**

1. Dispositif électroluminescent à semi-conducteurs (60), comprenant :
une structure de relaxation de contraintes au-dessus d'une région structurale ayant une surface de matrice sur un substrat (62), ladite région structurale contenant de l'aluminium en une première concentration ; et en dessous, une couche active semi-conductrice (72) contenant de l'aluminium en une seconde concentration qui est inférieure à ladite première concentration ; et dans lequel ladite structure de relaxation de contraintes comprend :

une pluralité de groupes (68, 70) d'au moins deux couches par groupe, au moins une couche de chacun desdits groupes étant constituée au moins en partie d'aluminium afin que chaque groupe ait une concentration moyenne en aluminium, la concentration moyenne en aluminium variant d'un groupe à l'autre de sorte que la concentration moyenne en aluminium dans le groupe (68) le plus proche de la couche de matrice (64) corresponde ou approche la première concentration et la concentration moyenne en aluminium dans le groupe (70) le plus proche de la couche active (72) corresponde ou approche la seconde concentration ;
dans lequel chaque groupe (68, 70) comprend au moins un sous-groupe de couches, une première couche du sous-groupe de couches étant constituée au moins en partie d'aluminium et une deuxième couche du sous-groupe de couches ne comprenant pas d'aluminium.

2. Dispositif électroluminescent à semi-conducteurs selon la revendication 1, dans lequel la concentration moyenne en aluminium est supérieure dans le groupe (68) le plus proche de la couche de matrice (64) par rapport à tous les groupes dans la structure de relaxation de contraintes, et la concentration moyenne en aluminium est inférieure dans le groupe (70) le plus proche de la couche active semi-conductrice (72) par rapport à tous les groupes dans la structure de relaxation de contraintes.

3.  Dispositif électroluminescent à semi-conducteurs selon l'une quelconque des revendications précédentes, dans lequel la couche active semi-conductrice (72) est une région active d'hétérostructure à multiples puits quantiques.

4.  Dispositif électroluminescent à semi-conducteurs selon l'une quelconque des revendications précédentes, dans lequel la concentration moyenne en aluminium dans le groupe (68) le plus proche de la couche de matrice (64) est dans la plage de 70 à 85 %, et la concentration moyenne en aluminium dans le groupe (70) le plus proche de la couche active semi-conductrice (72) est dans la plage de 50 à 65 %.

5.  Dispositif électroluminescent à semi-conducteurs selon l'une quelconque des revendications précédentes, dans lequel la concentration moyenne en aluminium varie linéairement d'un groupe à l'autre le long de la hauteur de la structure de relaxation de contraintes.

6.  Dispositif électroluminescent à semi-conducteurs selon la revendication 1, dans lequel la couche de matrice (64) est constituée d'AlN.

7.  Dispositif électroluminescent à semi-conducteurs selon l'une quelconque des revendications précédentes, comprenant en outre une couche d'interface (66) formée au-dessus de ladite couche de matrice (64) et en dessous de ladite couche de relaxation des contraintes (66) ayant une composition correspondant à la composition de ladite couche de matrice (64).

$10$

ACTIVE MQWH {

STRAIN RELIEF {

} 28-34
26
} 20-24
18
16
INTERFACE
14
TEMPLATE
12
SUBSTRATE

FIG. 1

$Al_{yn}Ga_{1-yn}N$

$Al_{xn}Ga_{1-xn}N$

⋮

} 46

$t_{yi}$ $Al_{y1}Ga_{1-y1}N$

$t_{xi}$ $Al_{x1}Ga_{1-x1}N$

$Al_xGa_{1-x}N$ — 44

$Al_xGa_{1-x}N$ — 42

SUBSTRATE — 40

FIG. 2

FIG. 3

FIG. 4

*FIG. 5*

EP 2 037 506 B1

_60_

| Layer | Repetition |
|---|---|
| 20 nm GaN: Mg, 0.2 nm/sec | |
| 3.49 nm $Al_{.35}Ga_{.65}N$: Si, 0.218 nm/sec | 21X |
| 3.82 nm $Al_{.30}Ga_{.70}N$: Si, 0.191 nm/sec | |
| 65.52 nm $Al_{.33}Ga_{.67}N$: Mg, 0.0546 nm/sec | |
| 21.88 nm $Al_{.48}Ga_{.52}N$: Mg, 0.0547 nm/sec | |
| 4.08 nm $In_xAl_{.26}Ga_{.74}N$, 0.0243 nm/sec | |
| 2.33 nm $In_xAl_{.26}Ga_{.74}N$: Si, 0.0243 nm/sec | |
| 4.08 nm $In_xAl_{.26}Ga_{.74}N$, 0.0243 nm/sec | |
| 5.25 nm $In_xAl_{.23}Ga_{.77}N$, 0.0243 nm/sec | 5X |
| 4.08 nm $In_xAl_{.26}Ga_{.74}N$, 0.0243 nm/sec | |
| 2.33 nm $In_xAl_{.26}Ga_{.74}N$: Si, 0.0243 nm/sec | |
| 4.08 nm $In_xAl_{.26}Ga_{.74}N$, 0.0243 nm/sec | |
| 70.56 nm $In_xAl_{.33}Ga_{.67}N$: Si, 0.0588 nm/sec | |
| 3.82 nm $Al_{.30}Ga_{.70}N$: Si, 0.1911 nm/sec | 101X |
| 3.49 nm $Al_{.35}Ga_{.65}N$: Si, 0.2182 nm/sec | |
| 1.09 nm $Al_{.35}Ga_{.65}N$: Si, 0.2182 nm/sec | |
| 1222.2 nm $Al_{.34}Ga_{.66}N$: Si, 0.2716 nm/sec | |
| 162.96 nm $Al_{.34}Ga_{.66}N$, 0.2716 nm/sec | |
| 0.25 nm GaN, 0.05 nm/sec | 41 X |
| 0.38 nm AlN , 0.05 nm/sec | |
| 0.25 nm GaN, 0.05 nm/sec | 40 X |
| 1 nm AlN, 0.032 nm/sec | |
| 28.8 nm AlN, 0.032 nm/sec | |
| 1000 nm AlN template | |
| Sapphire Substrate | |

Reference labels: 88, 72, 86, 84, 80, 82, 78, 76, 74, 71, 70, 68, 66, 64, 62

FIG. 6

LED WITH NEW DUAL PERIOD STRAIN RELIEF LAYER

LED WITH PREVIOUS STRAIN RELIEF DESIGN

LIGHT OUTPUT (COUNTS)

WAVELENGTH(nm)

*FIG. 7*

FIG. 8

## REFERENCES CITED IN THE DESCRIPTION

**Patent documents cited in the description**

- US 6875627 B, Bour
- US 35676906 A, Wong
- US 20070108456 A1
- US 20060118820 A1, Gaska R.
- US 356769 A

**Non-patent literature cited in the description**

- **HAN et al.** *Appl. Phys. Lett,* 2001, vol. 78, 67
- **NAKAMURA et al.** *J. J. Appl. Phys.,* 1997, vol. 36, 1568
- **CHEN et al.** *Appl. Phys. Lett.,* 2002, vol. 81, 4961
- **REN Z. et al.** Growth, characterization, and application of high Al-content AlGaN and high power III-nitride ultraviolet emitters. *Mater. Res. Soc. Symp. Proc.,* 2005, vol. 831, 21-26
- **ADIVARAHAN V. et al.** 250 nm AlGaN light-emitting diodes. *Appl. Phys. Lett.,* 2004, vol. 85, 2175-2177